(19) Europäisches Patentamt
European Patent Office
Office européen des brevets

(11) **EP 2 945 289 A1**

(12) **EUROPEAN PATENT APPLICATION**

(43) Date of publication:
**18.11.2015 Bulletin 2015/47**

(51) Int Cl.:
*H03M 5/22* (2006.01)        *H04L 27/10* (2006.01)
*H04B 1/69* (2011.01)

(21) Application number: **15167113.8**

(22) Date of filing: **11.05.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **12.05.2014   CN 201410199098**

(71) Applicant: **Great Union Technology Limited Kowloon (HK)**

(72) Inventor: **Yan, Lixin KOWLOON (HK)**

(74) Representative: **Karakatsanis, Georgios Haft Karakatsanis Patentanwaltskanzlei Dietlindenstrasse 18 80802 München (DE)**

(54) **A PULSE COMPRESSION METHOD FOR CHIRP SIGNAL AND WIRELESS TRANSCEIVER THEREOF**

(57)    A pulse compression method for CHIRP signal and a wireless transceiver thereof; pulse compression processing of a cycle $C_k$ has the following steps: analytically obtaining all instantaneous frequency components of instantaneous signals and then isolating out a corresponding amplitude; using storage spaces $M_n$ to store the amplitude and phase of each of the instantaneous frequency components; setting $T_n$ as a length of time from $t_n$ to an end time of the corresponding cycle; calculating $T_n$ according to formula $T_n = T - t_n$; using another set of storage spaces $M_T$ to rearrange amplitudes of the different instantaneous frequency components; storing the amplitude of each of the instantaneous frequency components in a set of $T_n$ value corresponding storage spaces of $M_T$ space; and accumulating overlapping amplitudes of instantaneous frequency components into another space in the storage spaces $M_T$.

FIG.3

**Description**

Technical Field

The present invention relates to a pulse compression method for CHIRP signal, and a wireless transceiver based on the pulse compression method.

Background Art

CHIRP signal is a linear frequency modulated signal, an instantaneous frequency of which is represented by the following formula:

$$f(t) = f_0 + s\,t \quad 0 < t < T$$

wherein $f_0$ is a starting frequency of the CHIRP signal, s is a frequency sweeping rate; s > 0 indicates an UP CHIRP where CHIRP signal frequency increases over a signal cycle; s < 0 indicates a DOWN CHIRP where CHIRP signal frequency decreases over a signal cycle. It is known from the above formula that an instantaneous frequency of any time corresponds to that particular time, and it is an inherent property of a CHIRP signal.

In CHIRP signal processing, dispersive delay line (DDL) is widely implemented to produce CHIRP signal and to realize pulse compression. Traditional DDL is realized by surface acoustic wave (SAW) devices, and once realized, its parameter characteristics are fixed and cannot be adjusted. If a high BT (B: bandwidth; T: time) value of a CHIRP signal is required, especially when a high value of T is required, the SAW devices will be very costly to be made and will be bulky, thereby not suitable to be used in modern communication system. Existing digital DDL methods usually use the design of digital filters, according to which DFT and IDFT transform algorithms are used, thereby consuming many computing machine cycle time resources and involving higher costs. These existing methods are not suitable to be used when high value of T is required.

Disclosure of the Invention

In view of the disadvantages now existing in the prior arts including long computing cycle during pulse compression of CHIRP signal, the necessity of signal synchronization with the CHIRP signal, complicated system and high costs, the present invention pertaining to a pulse compression method for CHIRP signal is provided to overcome these disadvantages.

The present invention also provides a wireless transceiver based on the pulse compression method for CHIRP signal.

A pulse compression method for CHIRP signal according to the present invention is described as follows: In the pulse compression method for CHIRP signal, CHIRP signals are set to be $C_1, C_2, C_3, \ldots\ldots C_k \ldots\ldots C_K$, whereas $1 \leq k \leq K$, wherein K represents a quantity of CHIRP cycles required to be transmitted in one complete communication. A pulse compression processing of a particular CHIRP cycle $C_k$ comprises the following steps:

S1: analytically obtaining all instantaneous frequency components of instantaneous signals and then isolating out a corresponding amplitude of each of the instantaneous frequency components so that the amplitude and phase of each of the instantaneous frequency components are obtained.

S2: using storage spaces $M_n$ to store the amplitude and phase of each of the instantaneous frequency components obtained in step S1; positioning sequence of the storage spaces $M_n$ corresponds to a sequence of the instantaneous frequency components.

S3: setting $t_n$ as a point of time when any one instantaneous frequency component $f_n$ of the instantaneous frequency components occurs in the corresponding particular CHIRP cycle; setting $\tau_n$, as a length of time from $t_n$ to an end time of the corresponding particular CHIRP cycle; calculating $\tau_n$ according to formula $T_n = T - t_n$.

S4: using another set of storage spaces $M_T$ to rearrange amplitudes of the different instantaneous frequency components occurring at different points of time and then disappearing at any other point of time in the particular CHIRP cycle $C_k$ in a sequence based on $T_n$ values; storing amplitude of each of the instantaneous frequency components in the set of $T_n$ value corresponding storage spaces $M_T$ space; accumulating amplitudes of instantaneous frequency components overlapping in a same space of the storage spaces $M_T$ into another space in the storage spaces $M_T$. T represents time duration of a CHIRP cycle; wherein $0 \leq n \leq N$.

In the above step S3, all values of $T_n$ are calculated in advance, and the obtained values of $T_n$ are stored in the storage spaces $M_n$ together with and correspondent to arrays of amplitudes and phases of the instantaneous frequency components.

A wireless transceiver based on said pulse compression method for CHIRP signal comprises an interface controller, a power saving controller, an IQ modulator, an IQ demodulator, bandpass filters (BFs) and an antenna for transmitting and receiving.

The wireless transceiver also comprises a microprocessor and Field Programmable Gate Array (FPGA). The microprocessor is connected with the FPGA, the interface controller and the power saving controller. Along the uplink, FPGA is connected with the antenna via the IQ modulator and the BFs. Along the downlink, FPGA is connected with the antenna via the IQ demodulator and the BFs.

The microprocessor and FPGA communicate to realize two-way data transmission and to transmit control commands to FPGA. FPGA is used for CHIRP signal generation, pulse compression processing of the CHIRP signal, MAC protocol analysis and MAC data packet formation.

In said wireless transceiver, FPGA comprises CHIRP generator, MAC protocol analyzer and pulse compression processor. The microprocessor is connected with the CHIRP generator, the MAC protocol analyzer and the pulse compression processor. Along the uplink, the CHIRP generator is connected with the antenna via the IQ modulator and the BFs. Along the downlink, the pulse compression processor is connected with the antenna via the IQ demodulator and the BFs.

In said wireless transceiver, the wireless transceiver also comprises a low noise amplifier (LNA) and amplitude detection circuit along the downlink. The LNA is connected with a BF to amplify the output signal from the BF. The amplitude detection circuit is used for detecting the output amplitude of the LNA and realizing feedback gain control of LNA.

Several CHIRP signal generating modules having different BT values are preset in the CHIRP signal generator, and correspondingly, several pulse compression modules having different BT values are preset in the pulse compression processor. In each pulse compression modules having a corresponding BT value, UP CHIRP compression algorithm and DOWN CHIRP compression algorithm are provided. The microprocessor and FPGA will use several combinations of BT values to perform pulse compression processing of input CHIRP signal at the same time. The pulse compression module having a BT value matching the actual CHIRP signal will generate compressed pulse.

The core inventive concept of the present invention is that the principle of pulse compression method for CHIRP signal is different from that of existing prior arts. Firstly, all the frequency components of instantaneous signals are analyzed to obtain the corresponding amplitude of each of the frequency components. Coding the storage units in advance based on time sequence, store and accumulate each amplitude and frequency component obtained by signal analysis at each point of time to a respective storage unit corresponding to a respective point of time, according to the inherent law of CHIRP signal that an instantaneous frequency of a CHIRP signal at any point of time will only occur at that point of time and then disappear. After the complete cycle of CHIRP signal processed, there will be accumulative peak value calculated out of all the data in certain storage units. This would complete the pulse compression processing.

The present invention has the following advantages and beneficial effects compared with prior arts:

1. The compression method for CHIRP signal according to the present invention occupies less machine computing cycles, and does not require synchronization of the CHIRP signal being processed. This would reduce the time cost to be incurred during realization of pulse compression processing of CHIRP signal.

2. Due to the use of storage spaces for temporary data storage for processing intermediate results, the T value of CHIRP signal corresponds to the size of the storage spaces being used. Due to the current progress of semiconductor technology, large storage space is also very cheap. Therefore, the method of the present invention reduces the costs for hardware resources during realization of pulse compression processing of CHIRP signal.

3. The wireless transceiver is based on said pulse compression method for CHIRP signal. The wireless transceiver uses FPGA for pulse compression, MAC protocol analysis and CHIRP signal generation. Since the pulse compression method for CHIRP signal consumes only a very small amount of time and hardware resources, the requirements for the performance standard of FPGA can be lowered, thereby lowering the costs of the wireless transceiver. This advantage of low costs is particularly obvious especially in voluminous production.

4. Since the pulse compression method for CHIRP signal does not require CHIRP signal synchronization, complexity of the design of the wireless transceiver can be significantly reduced. Also, an increased response speed of the wireless transceiver in response to the pulse compression method for CHIRP signal can be achieved.

5. By using FPGA, the wireless transceiver can integrally perform the various functions of the microprocessor, such as the interface controller and the power saving controller etc, building a foundation for integration of an integral transceiver chip (digital and analog integrated as a whole). The wireless transceiver can process CHIRP signal with narrow bandwidth and long time duration, and can be widely applied to occasions where wide bandwidth is not required but high sensitivity reception is highly required, for example in data transmission and reception between wireless sensors under a point-to-point basis or point-to-multi-points basis distributed as far as dozens of or even a hundred miles away.

Brief Description of Drawings

FIG. 1 shows the waveform of an UP CHIRP.
FIG. 2 shows the change of frequency of an UP CHIRP.
FIG. 3 shows the accumulation of the amplitudes of the instantaneous frequency components.
FIG. 4 is a structural diagram of the wireless transceiver.

Best Mode for Carrying out the Invention

The present invention is described in further detail below with reference to an embodiment and the accompanying drawings. However, the present invention should not be considered limited to the description below.

Embodiment

In a CHIRP SPREAD SPECTRUM (CSS) communication system, a transmitter transmits a series of CHIRP signals to the air, represented as $C_1, C_2, C_3, ...... C_k ...... C_K$, whereas $1 \leq k \leq K$, wherein K represents a quantity of CHIRP cycles required to be transmitted in one complete communication. Set the time duration of a CHIRP cycle as T, and bandwidth as B.

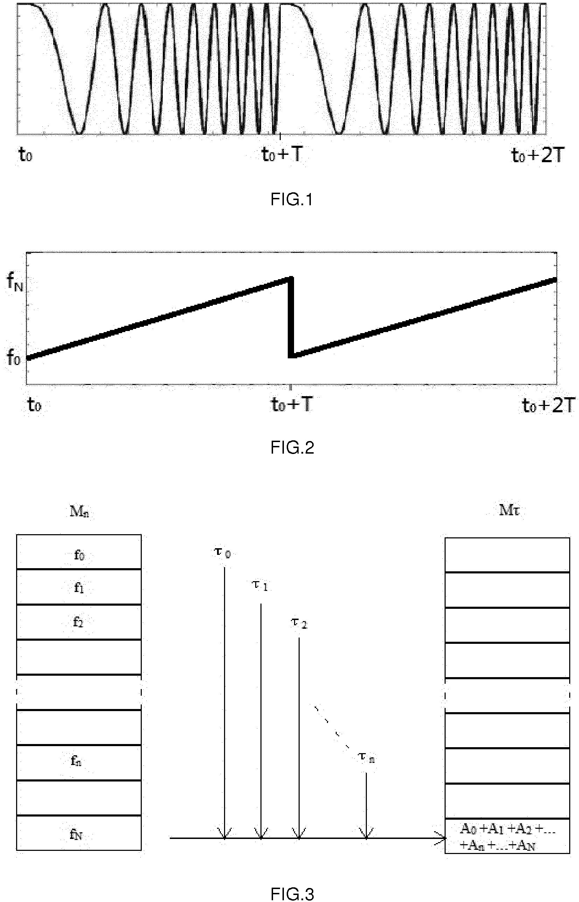

Figure 1 shows a typical cyclic UP CHIRP. UP CHIRP has the property of constant amplitudes and changing frequency along a linear timeline, as shown in figure 2, and its time duration of a CHIRP cycle is defined as T, so that $t_N = t_0 + T$, and its signal's bandwidth is defined as $B = f_N - f_0$. Obviously, when a transceiver receives a particular CHIRP signal, instantaneous frequency components (any one of which can be represented as $f_n$, and $0 \leq n \leq N$) will occur according to time sequence, in other words, an $f_n$ will only occur at a point of time $t_n$ ($0 \leq n \leq N$) and disappear at any other point of time.

The pulse compression processing for CHIRP signal according to the present invention is to perform a sequence of different time delayed operations with respect to different instantaneous frequency components. In other words, the present invention accumulates amplitudes of different instantaneous frequency components overlapping in the same storage space, so that different instantaneous frequency components existed following the time sequence achieve energy accumulation and result as a detectable pulse signal.

According to the pulse compression processing for CHIRP signal of the present invention, the first step is to analytically obtain all instantaneous frequency components of instantaneous signals and then obtain a corresponding amplitude of each of the instantaneous frequency components so that an array of amplitude and phase of each of the instantaneous frequency components is obtained. The method of obtaining the instantaneous frequency components of the instantaneous signals is not limited to a particular method, but can be any method which is commonly available. In the present embodiment, the present invention uses Fast Fourier Transformation (FTT) algorithm to obtain the instantaneous frequency components. The result of FTT algorithm is an array of amplitude and phase of each of the instantaneous frequency components. Table 1 below shows arrays of amplitudes and phases of the instantaneous frequency components each occurring in a particular point of time:

Table 1

| $f_0$ | $f_1$ | $f_2$ | ... | $f_n$ | ... | $f_N$ |
|---|---|---|---|---|---|---|
| $A_0$ | $A_1$ | $A_2$ | ... | $A_n$ | ... | $A_N$ |
| $\phi_0$ | $\phi_1$ | $\phi_2$ | ... | $\phi_n$ | ... | $\phi_N$ |

The arrays of amplitudes and phases of the instantaneous frequency components as shown in Table 1 are stored in storage spaces $M_n$. Positioning sequence of the storage spaces $M_n$ corresponds to a sequence of the above instantaneous frequency components. In other words:

Amplitude and phase of $f_0$ are stored at $M_0$; amplitude and phase of $f_1$ are stored at $M_1$; amplitude and phase of $f_2$ are stored at $M_2$;......; amplitude and phase of $f_n$ are stored at $M_n$.

Table 2 below shows a table form of the corresponding relationships between the above instantaneous frequency components and the positioning sequence of the storage spaces $M_n$:

Table 2

| $f_0$ | $f_1$ | $f_2$ | $\cdots$ | $f_n$ | $\cdots$ | $f_N$ |
|---|---|---|---|---|---|---|
| $M_0$ | $M_1$ | $M_2$ | $\cdots$ | $M_n$ | $\cdots$ | $M_N$ |
| $A_0$ | $A_1$ | $A_2$ | $\cdots$ | $A_n$ | $\cdots$ | $A_N$ |
| $\phi_0$ | $\phi_1$ | $\phi_2$ | $\cdots$ | $\phi_n$ | $\cdots$ | $\phi_N$ |

Accuracy of instantaneous frequency components obtained through digitization processing of discrete signals is limited by sampling frequency and computing speed. If frequency accuracy is set as $\Delta f$, then:

$$f_0 = \Delta f$$

$$f_1 = f_0 + \Delta f$$

$$f_2 = f_1 + \Delta f$$

$$f_3 = f_2 + \Delta f$$

......

$$f_N = f_{N-1} + \Delta f$$

When a certain frequency is $f_a$, and $f_{n-1} \leq f_a < f_n$, n=1,2,3,..., N+1, amplitude and phase corresponding to $f_a$ are stored in storage space $M_{n-1}$ corresponding to $f_{n-1}$.

In CSS communication, properties of CHIRP signals being transmitted are defined and are agreed in advance by both the transmitting party and the receiving party. In other words, in any CHIRP cycle $C_k$, a point of time corresponding to the occurrence of a particular instantaneous frequency component can be determined. Alternatively speaking, when a receiver analytically discovers a certain instantaneous frequency component $f_n$ in a received signal, the point of time $t_n$ at which this particular instantaneous frequency component $f_n$ occurs in the corresponding CHIRP cycle can be determined. $\tau_n$ represents a length of time from $t_n$ to an end time of the corresponding particular CHIRP cycle; $T_n$ is calculated according to formula $T_n = T - t_n$, where $0 \leq n \leq N$. In storage spaces $M_n$, values of $T_n$ are stored corresponding to arrays of amplitudes and phases of the instantaneous frequency components, as shown in Table 3 below:

Table 3

| $f_0$ | $f_1$ | $f_2$ | $\cdots$ | $f_n$ | $\cdots$ | $f_N$ |
|---|---|---|---|---|---|---|
| $M_0$ | $M_1$ | $M_2$ | $\cdots$ | $M_n$ | $\cdots$ | $M_N$ |
| $A_0$ | $A_1$ | $A_2$ | $\cdots$ | $A_n$ | $\cdots$ | $A_N$ |
| $\phi_0$ | $\phi_1$ | $\phi_2$ | $\cdots$ | $\phi_n$ | $\cdots$ | $\phi_N$ |
| $T_0$ | $T_1$ | $T_2$ | $\cdots$ | $T_n$ | $\cdots$ | $T_N$ |

When receiver at any time starts to process a received signal, the signal it will process is a signal occurring at a particular point of time $t_n$ in a particular cycle $C_k$ among the $K^{th}$ cycles of the CHIRP signals. Through analytical computing of instantaneous frequency, the receiver can obtain data such as instantaneous frequency component $f_n$ and amplitude $A_n$ of that signal occurring at that particular point of time, and at the same time obtain a corresponding value $T_n$ of the instantaneous frequency component $f_n$ through computing. In actual algorithm, the corresponding value $T_n$ is computed in advance by the formula $T_n = T - t_n$, stored in Table 3, and is found by checking Table 3 based on its corresponding instantaneous frequency component $f_n$.

Next, using another set of storage spaces $M_T$ in storage units to rearrange amplitudes of the different instantaneous frequency components occurring and disappearing at different points of time in the particular CHIRP cycle $C_k$ in a sequence based on $T_n$, values, that is, storing the amplitude of each of the instantaneous frequency components in a set of $T_n$ value corresponding storage spaces $M_T$ space. If two or more different instantaneous frequency components overlap in the same spaces of the storage spaces $M_T$, their amplitudes are accumulated respectively, as shown in figure 3. In theory, the different instantaneous frequency components in the CHIRP cycle $C_k$ will occur and disappear continuously and sequentially according to time sequence (increasing frequency UP CHIRP or decreasing frequency DOWN CHIRP), and the receiving end will base on the above algorithm to accumulate all amplitudes of different instantaneous frequency components overlapping in the same spaces of the storage spaces $M_T$ into an accumulation space in the storage spaces $M_T$. If values of $M_T$ are plotted according to time sequence, a pulse having a very high peak value will be resulted.

The above processes complete the pulse compression of a CHIRP signal. Repeat the above processes so as to complete the pulse compression for CHIRP signals for the entire series of cycles $C_K$. After that, in the accumulated space of the storage spaces $M_T$, a series of peak value can be achieved. After pulse peak value identification, modulated signal is recovered and data communication can be realized.

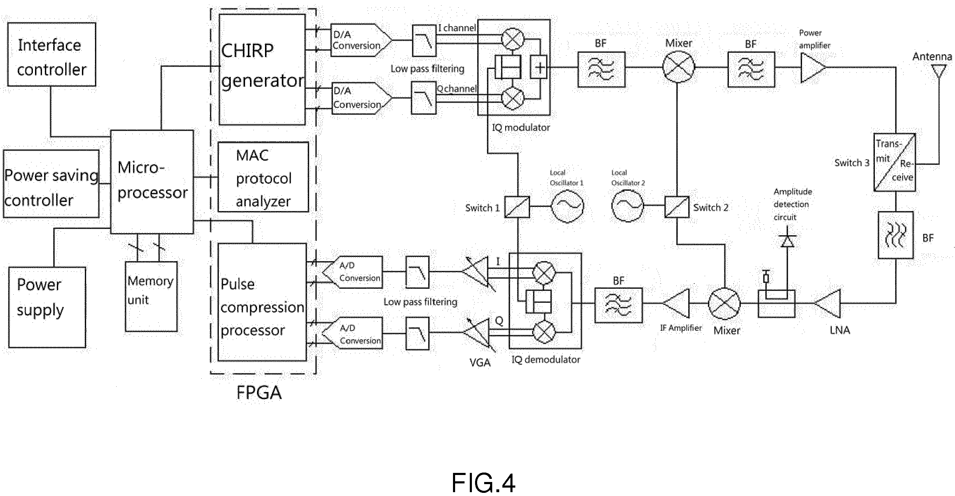

A wireless transceiver based on the above pulse compression method for CHIRP signal has a structure illustrated in figure 4, comprising Field Programmable Gate Array (FPGA), microprocessor, interface controller, power saving controller, memory unit, IQ modulator, IQ demodulator, bandpass filters (BFs) and an antenna for transmitting and receiving. FPGA comprises CHIRP generator, MAC protocol analyzer and pulse compression processor. The microprocessor is connected with the CHIRP generator, the MAC protocol analyzer, the pulse compression processor, the interface controller, the power saving controller and the memory unit. Along the uplink (transmission links), the CHIRP generator is connected with the antenna via the IQ modulator and the BFs. Along the downlink (reception links), the pulse compression processor is connected with the antenna via the IQ demodulator and the BFs. The storage units or storage spaces according to the pulse compression method for CHIRP signal of the present invention can be configured but not necessarily to be configured in the memory unit of the above wireless transceiver, in fact, they can be configured in storage units internal to the FPGA.

A greater spread spectrum gain can be obtained when choosing a higher BT value of CHIRP signal in CHIRP communication. When small signal processing unit in wireless communication has a greater spread spectrum gain, its signal receiving sensitivity will have greater improvements, so that useful signal buried in noise can be identified. The use of the pulse compression method for CHIRP signal according to the present invention in the design of the above transceiver achieves ideal actual results. Pulse compression of CHIRP signal can obtain spread spectrum gain. Magnitude of the gain is closely related to CHIRP signal frequency change range B and time duration T of the CHIRP signal in one single cycle. The essence of the present invention is to change the value T to adapt to the need for spread spectrum gain, and at the same time control the value B to a low value and suppress external noises from entering the receiver through the assistance of appropriate filters. A detailed configuration can be given as follows:

Value B (i.e. frequency bandwidth of CHIRP signal) is fixed in advance, so that BT value can be changed by only changing the CHIRP signal time duration value T (i.e. time duration of a CHIRP cycle). In other words, different BT values can be obtained by changing the value T. Therefore, several different BT values being preset will have the same value B. In the FPGA, several CHIRP signal generating modules having different BT values are preset in the CHIRP signal generator, and correspondingly, several pulse compression modules having different BT values are preset in the pulse compression processor. In the pulse compression modules corresponding to each BT value, UP CHIRP compression algorithm and DOWN CHIRP compression algorithm are provided. According to the compression principle of the pulse compression method of the present invention, UP CHIRP compression algorithm will only compress UP CHIRP signal into a pulse whereas DOWN CHIRP signal will be processed as a result of background noise which will be distributed over the entire signal cycle and will not generate any pulse. The same applies to DOWN CHIRP algorithm. Likewise, according to the compression principle of the pulse compression method of the present invention, UP CHIRP compression algorithm and DOWN CHIRP compression algorithm with respect to a particular BT value will only be sensitive to CHIRP signal with that particular BT value. In other words, only CHIRP signal matching with corresponding pulse compression BT value will generate a pulse during compression.

In an actual system application, apparatus at the two communicating sides will try to transmit data by using CHIRP signals with different BT values during an initial communication; a particular BT value will then be preferably determined after measurement of signal-to-noise ratio. The design principle of the present invention is to obtain the largest bandwidth, meaning the lowest BT value, on condition that the communication is reliable. An overly high BT value is avoided so as to prevent sacrificing data transmission bandwidth while allowing better receiving sensitivity.

In figure 4, the tasks of FPGA mainly comprise CHIRP signal generation, pulse compression processing, MAC protocol analysis and MAC data packet formation. The microprocessor and FPGA communicate to realize two-way data transmission and to transmit control commands to FPGA to complete the selection and control of the above tasks of FPGA. The operating condition of FPGA is informed to the microprocessor via changes of pin power level of components. When the device is powered, the microprocessor transmits transmit-receive enabling commands to FPGA based on requirements of the task to be performed. When the task requires transmission of data, the microprocessor transmits a "transmit" control command to FPGA, and next transfers to FPGA the data that FPGA requires to transmit; when FPGA receives the command and data, the data is packaged as MAC data frame that has to be transmitted, and the data is then being transformed as a series of CHIRP pulses by the CHIRP signal generator inside FPGA, and then being transmitted. The data then goes through various conversion circuit units and eventually arrives at the antenna where the data will be emitted. When the task requires data reception, the microprocessor transmits a "receive" control command to FPGA, and FPGA will then begin pulse compression processing procedures; FPGA will extract data signal from reception return circuit and then perform MAC protocol analysis of the received data signal (usually data formed by a series of numerals 0 and 1); the protocol frame is then unpacked as useful data which is sent to the microprocessor for subsequent processing. The microprocessor at the same time controls the interface controller to facilitate communication between the transceiver and related sensors or actuators in the periphery including I/O channels, analog input channels (A/D conversion) and USB ports etc. The power saving controller is controlled by the microprocessor, so that the device is operated according to several different power supply modes to achieve overall low power consumption of the transceiver, for example, transmission and reception fully functioning (normal mode), power supply to reception part only (interception mode), interface controller in operation only (maintenance mode), microprocessor in operation only (standby mode) and power supply to memory unit only (sleep and storage mode) etc.

CHIRP signal frequency change range B (i.e. bandwidth) and time duration T (i.e. cycle) generated by the CHIRP generator are selected and varied by FPGA according to the control signals from the microprocessor to obtain various spread spectrum gain, and the digital modulation coding of which is also completed by the CHIRP generator. CHIRP signal generated by CHIRP generator is a series of digital signals which are output in parallel manner along an I channel and a Q channel respectively. Data in IQ channels is transformed into analog signals via D/A conversion and then being transmitted to IQ modulator to form high frequency signal, which is then being transformed as RF signal via BFs and mixer, and the RF signal will go through power amplifier and RF switch etc and then being transmitted to the antenna for emission to the air.

In the reception links, RF signal in the air as received will first be processed by BF to eliminate clutter (noise wave) of the band, and then being amplified by low noise amplifier (LNA). In the reception links, a protective measure for LNA is provided; the protective measure is amplitude detection circuit, which is for detecting the output amplitude of LNA and realizing feedback gain control of LNA so as to guarantee that the LNA always maintains a linearity operating condition, thereby reducing deterioration of signal-to-noise ratio. The RF signal will then be transmitted to a mixer to output an Intermediate frequency (IF) signal, which is then being amplified and subject to wave filtering again and then being transmitted to IQ demodulator where analog signal for IQ channels is isolated and obtained. Variable gain amplifier (VGA) and low pass filtering are arranged to process the analog signal to filter clutter (noise wave) of the band to increase dynamic range.

After A/D conversion, IQ channels signal is transmitted to FPGA for pulse compression processing where the inventive software technology algorithm of the present invention is employed. The microprocessor and FPGA of the wireless transceiver will use several combinations of BT values to perform pulse compression processing of input CHIRP signal at the same time. Only the pulse compression algorithm having a BT value matching with the actual CHIRP signal will generate compressed pulse. In other words, the pulse compression module having a BT value matching the actual CHIRP signal will generate compressed pulse. The pulse obtained corresponds to bit, and a data string will then be obtained via continuous processing, and after that an actual useful data will be obtained via MAC protocol analysis. The microprocessor fully controls the various processing procedures of FPGA to obtain the correct data and to complete the tasks of transmission and reception.

The above embodiment is a preferred embodiment of the present invention, but the implementation of the present invention should not be limited by the above embodiment. Any changes, modifications, replacements, combinations and simplification without deviating from the essence and principle of the present invention are all effective equivalents and should therefore fall within the scope of protection of the present invention.

**Claims**

1. A pulse compression method for CHIRP signal;
   let $C_1, C_2, C_3, \ldots\ldots C_k \ldots\ldots C_K$ be CHIRP signals, whereas $1 \leq k \leq K$, and K represents a quantity of CHIRP cycles required to be transmitted in one complete communication; **characterized in that**:

   pulse compression processing of a particular CHIRP cycle $C_k$ comprises the following steps:

   S1: analytically obtaining all instantaneous frequency components of instantaneous signals and then isolating out a corresponding amplitude of each of the instantaneous frequency components to obtain the amplitude and phase of each of the instantaneous frequency components;
   S2: using storage spaces $M_n$ to store the amplitude and phase of each of the instantaneous frequency components obtained in step S1; positioning sequence of the storage spaces $M_n$ corresponds to a sequence of the instantaneous frequency components;
   S3: setting $t_n$ as a point of time when any one instantaneous frequency component $f_n$ of the instantaneous

frequency components occurs in the corresponding particular CHIRP cycle; setting $T_n$, as a length of time from $t_n$ to an end time of the corresponding particular CHIRP cycle; calculating $T_n$ according to formula $T_n = T - t_n$;

S4: using another set of storage spaces $M_T$ to rearrange amplitudes of the different instantaneous frequency components occurring at different points of time and then disappearing at any other point of time in the particular CHIRP cycle $C_k$ in a sequence based on $T_n$ values; storing amplitude of each of the instantaneous frequency components in the set of $T_n$ value corresponding storage spaces $M_T$ space; accumulating amplitudes of instantaneous frequency components overlapping in a same space of the storage spaces $M_T$ into another space in the storage spaces $M_T$;

T represents time duration of a CHIRP cycle; wherein $0 \leq n \leq N$.

2. The pulse compression method for CHIRP signal as in Claim 1, wherein in the above step S3, all $T_n$ values are calculated in advance, and the obtained $T_n$ values are stored in the storage spaces $M_n$ together with and correspondent to arrays of amplitudes and phases of the instantaneous frequency components.

3. The pulse compression method for CHIRP signal as in Claim 2, wherein storage of the $T_n$ values in the storage spaces $M_n$ together with and correspondent to arrays of amplitudes and phases of the instantaneous frequency components is presented as the following table:

| $f_0$ | $f_1$ | $f_2$ | $\cdots$ | $f_n$ | $\cdots$ | $f_N$ |
|---|---|---|---|---|---|---|
| $M_0$ | $M_1$ | $M_2$ | $\cdots$ | $M_n$ | $\cdots$ | $M_N$ |
| $A_0$ | $A_1$ | $A_2$ | $\cdots$ | $A_n$ | $\cdots$ | $A_N$ |
| $\phi_0$ | $\phi_1$ | $\phi_2$ | $\cdots$ | $\phi_n$ | $\cdots$ | $\phi_N$ |
| $T_0$ | $T_1$ | $T_2$ | $\cdots$ | $T_n$ | $\cdots$ | $T_N$ |

a corresponding value $T_n$ is found by checking the above table based on a respective corresponding instantaneous frequency component $f_n$.

4. The pulse compression method for CHIRP signal as in Claim 1, wherein in step S1, Fast Fourier Transformation (FTT) algorithm is used for analytically obtaining the amplitude and phase of each of the instantaneous frequency components.

5. A wireless transceiver based on the pulse compression method for CHIRP signal as in any one of Claims 1-4 comprises an interface controller, a power saving controller, an IQ modulator, an IQ demodulator, bandpass filters and an antenna for transmitting and receiving, **characterized in that**:

the wireless transceiver also comprises a microprocessor and a Field Programmable Gate Array (FPGA); the microprocessor is connected with the FPGA, the interface controller and the power saving controller; along an uplink, the FPGA is connected with the antenna via the IQ modulator and the bandpass filters; along a downlink, the FPGA is connected with the antenna via the IQ demodulator and the bandpass filters;

the microprocessor and the FPGA communicate to realize two-way data transmission and to transmit control commands to the FPGA; the FPGA is used for CHIRP signal generation, pulse compression processing of the CHIRP signal, Medium Access Control (MAC) protocol analysis and MAC data packet formation.

6. The wireless transceiver as in Claim 5, wherein the FPGA comprises a CHIRP generator, a MAC protocol analyzer and a pulse compression processor; the microprocessor is connected with the CHIRP generator, the MAC protocol analyzer and the pulse compression processor; along the uplink, the CHIRP generator is connected with the antenna via the IQ modulator and the bandpass filters; along the downlink, the pulse compression processor is connected with the antenna via the IQ demodulator and the bandpass filters.

7. The wireless transceiver as in Claim 5, wherein the wireless transceiver also comprises a Low Noise Amplifier (LNA) and a amplitude detection circuit along the downlink; the LNA is connected with a corresponding bandpass filter to amplify output signal from the corresponding bandpass filter; the amplitude detection circuit is used for detecting output amplitude of the LNA and realizing feedback gain control of the LNA so that the LNA always maintains a linearity operating condition.

8. The wireless transceiver as in Claim 6, wherein several CHIRP signal generating modules having different BT values are preset in the CHIRP generator, and correspondingly, several pulse compression modules having different BT values are preset in the pulse compression processor; in each of the pulse compression modules having a respective corresponding BT value, UP CHIRP compression algorithm and DOWN CHIRP compression algorithm are provided; the microprocessor and the FPGA use several combinations of BT values at the same time to perform pulse compression processing of CHIRP signal being input; among the pulse compression modules, a pulse compression module having a BT value matching the actual CHIRP signal being input generates a compressed pulse.

9. The wireless transceiver as in Claim 8, wherein in several pulse compression modules having different BT values, UP CHIRP compression algorithm and DOWN CHIRP compression algorithm are provided in each of the pulse compression modules having a respective corresponding BT value.

10. The wireless transceiver as in Claim 8, wherein the several different BT values have the same value B.

FIG.1

FIG.2

FIG.3

FIG.4

Europäisches
Patentamt

European
Patent Office

Office européen
des brevets

# EUROPEAN SEARCH REPORT

Application Number

EP 15 16 7113

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 278 724 A1 (NANOSCALE LABS [FR]) 26 January 2011 (2011-01-26) * paragraph [0041] - paragraph [0076]; figures 3-5 * | 1-10 | INV. H03M5/22 H04L27/10 H04B1/69 |
| X | B Raviteja Reddy ET AL: "Development of FPGA for Custom Waveform Generator Based on Direct Digital Synthesizer", International Journal of Engineering Research and Applications, 1 July 2013 (2013-07-01), pages 2597-2602, XP055216336, Retrieved from the Internet: URL:http://citeseerx.ist.psu.edu/viewdoc/download?doi=10.1.1.378.906&rep=rep1&type=pdf [retrieved on 2015-09-25] * abstract * * paragraph [000I] - paragraph [0III]; figures 3,8 * | 1-10 | |
| A | Hamza Mansoor Manya ET AL: "FPGA Implementation of a Runtime User Configurable Chirp Signal Generator", Journal of Space Technology, 1 July 2013 (2013-07-01), pages 13-18, XP055216457, Retrieved from the Internet: URL:http://www.ist.edu.pk/downloads/jst/previous-issues/june-2013/2-fpga-implementation-of-a-runtime-user-configurable-chirp-signal-generator.pdf [retrieved on 2015-09-28] * abstract * * paragraphs [000I], [00IV] * | 5-10 | TECHNICAL FIELDS SEARCHED (IPC) H03M H04B H04L |

The present search report has been drawn up for all claims

| Place of search | Date of completion of the search | Examiner |
|---|---|---|
| The Hague | 28 September 2015 | Belardinelli, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 15 16 7113

This annex lists the patent family members relating to the patent documents cited in the above-mentioned European search report.
The members are as contained in the European Patent Office EDP file on
The European Patent Office is in no way liable for these particulars which are merely given for the purpose of information.

28-09-2015

| Patent document cited in search report | | Publication date | Patent family member(s) | | Publication date |
|---|---|---|---|---|---|
| EP 2278724 | A1 | 26-01-2011 | CN | 102474297 A | 23-05-2012 |
| | | | EP | 2278724 A1 | 26-01-2011 |
| | | | EP | 2449690 A1 | 09-05-2012 |
| | | | JP | 5699142 B2 | 08-04-2015 |
| | | | JP | 2012531869 A | 10-12-2012 |
| | | | KR | 20120041210 A | 30-04-2012 |
| | | | US | 2011064119 A1 | 17-03-2011 |

EPO FORM P0459

For more details about this annex : see Official Journal of the European Patent Office, No. 12/82